Europäisches Patentamt

(19) European Patent Office

Office européen des brevets

(11) Publication number: **0 020 134**
A1

(12) # EUROPEAN PATENT APPLICATION

(21) Application number: 80301761.5

(22) Date of filing: 28.05.80

(51) Int. Cl.³: **C 30 B 1/08,** C 30 B 25/18, C 23 C 13/04

(30) Priority: 29.05.79 US 43541

(71) Applicant: **MASSACHUSETTS INSTITUTE OF TECHNOLOGY, 77 Massachusetts Avenue, Cambridge Massachusetts 02139 (US)**

(43) Date of publication of application: **10.12.80 Bulletin 80/25**

(72) Inventor: **Geis, Michael, W., 132, Parker Street Apt. 51, Acton Massachusetts 01720 (US)**
Inventor: **Flanders, Dale C., 15, Preston Road, Lexington Massachusetts 02173 (US)**
Inventor: **Smith, Henry I., 437, Peakham Road, Sudbury Massachusetts 01776 (US)**

(74) Representative: **Brunner, Michael John et al, Gill Jennings & Every 53 to 64, Chancery Lane, London WC2A 1HN (GB)**

(84) Designated Contracting States: **DE FR GB NL**

(54) Method of enhancing epitaxy and preferred orientation in films deposited on solid substrates.

(57) The invention relates to a method of enhancing epitaxy and preferred orientation in films on solid substrates, which includes forming at predetermined locations, a plurality of artificial point defects or a surface relief structure (7) at the surface of a solid substrate (1). Thereafter a film (8) is deposited on the surface to form a substantially epitaxial or preferred orientation layer in tre film having crystalographic orientation influenced by the geometry of an artificial defect. The orienting influence of the article defects may be enhanged by applying an incident beam of energy (9) to the film (8).

**TITLE MODIFIED**
see front page

- 1 -

MASSACHUSETTS INSTITUTE OF TECHNOLOGY    GJE 5180/064.

<u>IMPROVING GRAPHOEPITAXY</u>

This invention relates in general to improving the crystallographic quality of solid films grown on the surfaces of solid substrates, and more particularly to improved means for obtaining epitaxial or preferred orientation films on solid substrates, both crystalline and amorphous.

Much of modern technology makes use of thin solid films on the surfaces of solid substrates. Epitaxial and preferred orientation films are particularly important, notably in microelectronic devices, thin film optical devices and solar cells. Thus, improved methods of preparing epitaxial and preferred orientation films are of great importance.

A known method patent has been named "graphoepitaxy" (see "Crystallographic Orientation of Silicon on an Amorphous Substrate Using an Artificial Surface Relief Grating and Laser Crystallization", by M.W. Geis, D.C. Flanders and H.I. Smith, published in Applied Physics Letters July 1, 1979). The name is derived from the Greek "grapho" (meaning to write or incise) and was chosen to convey the principle of using an artificially created surface pattern in a solid substrate to induce epitaxy. The principle involved is the use of a plurality of artificial defects, formed at predetermined locations at the surface of a

- 2 -

solid substrate, to determine, control or influence by means of the geometric arrangement of adjacent defects (that is their shape, form and relative position in terms of bearing and distance), the crystallographic orientation of a film deposited on the surface. These artificial defects are either (1) artificial point defects or (2) artificial surface relief structure.

According to the first aspect of the present invention a method of enhancing expitaxy and preferred orientation in films on solid substrates, which method includes the steps of intentionally forming, at predetermined locations, a plurality of artificial defects at the surface of a solid substrate and thereafter depositing a film on the surface to form a substantially expitaxial or preferred orientation layer in the film having crystallographic orientation influenced by the geometry of an artificial defect, is characterized in that the orienting influence of the artificial defects is enhanced by applying an incident beam of energy to the film.

One or more artificial surface-relief or artificial point defects may be intentionally created at predetermined locations on a solid surface and thereafter material deposited to form a film over the solid surface. During or following the deposition of the film, the surface and/or the film of material deposited thereon is irradiated with electromagnetic or acoustic waves or energetic particles, thereby adding energy to the film and inducing or enhancing the influence that the artificial surface relief steps or point defects exert in orientating a layer in the film.

According to a second aspect of the invention a method of enhancing epitaxy and preferred orientation

- 3 -

in films on solid substrates, includes the step
of intentionally forming, at a predetermined location,
an artificial defect at the surface of a solid substrate,
the artificial defect comprising an artificial point
defect or an artificial step, and thereafter depositing
a film on the surface to form a substantially epitaxial
or preferred orientation layer in the film having
crystallographic orientation controlled by the geometry
of the artificial defect.

Preferably, the artificial defect has its
dimension in a direction perpendicular to the substrate
surface within the range of one atom to 1/2 micron.

The invention also includes a substrate having
an epitaxial or preferred orientation layer formed
on its surface by the method of the second aspect
of the invention. The second aspect of the present
invention is an improvement on the basic principle
benefiting from the appreciation that the position,
orientation and geometrical form of a single defect,
such as a relief step or other structure, can be
sufficient to determine the orientation of a layer
in a film. In such situations, other artificial
defects may be present at the surface, but their
adjacency is not the determinant in crystallographic
orientation.

According to a third aspect of the invention
a method of enhancing epitaxy and preferred orientation
in films on solid substrates which method includes
the steps or intentionally forming at predetermined
locations a plurality of artificial defects at the
surface of a solid substrate, the artificial defects
comprising artificial point defects or artificial
surface relief structure, and thereafter depositing
a film on the surface to form a substantially epitaxial
or preferred orientation layer in the film having
crystallographic orientation controlled by the geometric

0020134

- 4 -

arrangement of adjacent artificial defects is characterized in that artificial steps having sloping walls are formed among the artificial defects, the sloping walls being parallel to one another and inclined at an angle of substantially $70.5^{\circ}$ or $109.5^{\circ}$ to the substrate surface.

The invention will now be described with reference to the accompanying drawings in which:-

Figure 1 is a diagrammatic representation showing a substrate covered with a thin chromium film as a stage in the process according to the invention;

Figure 2 illustrates how a resist film over the thin film is exposed with radiant energy as a further stage;

Figure 3 is a diagrammatic representation of the grating relief structure which remains in the resist following its development;

Figure 4 illustrates the stage of etching through the chromium;

Figure 5 illustrates the relief grating formed in the substrate following the etching;

Figure 6 illustrates the structure with a thin film of silicon form over the relief structure;

Figure 7 is a pictorial representation of apparatus for laser crystallization in practicing the invention;

Figure 8 illustrates a substrate having a single relief step etched into its surface; and

Figure 9 illustrates a substrate having relief structure including facets which intersect substantially at the intersection angles of the (111) planes in cubic crystals.

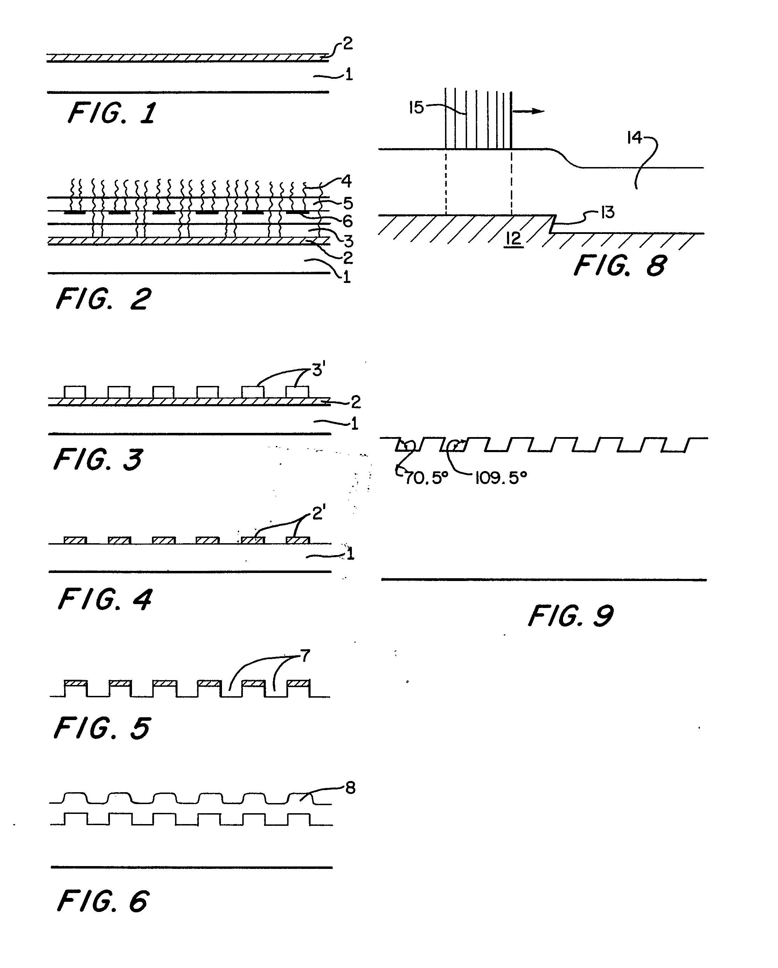

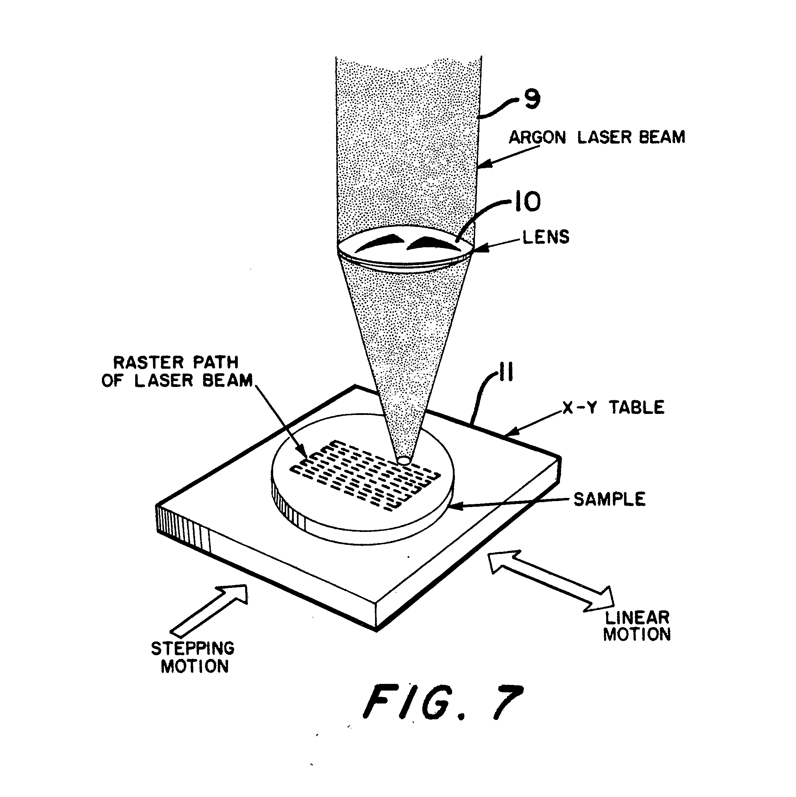

With reference now to the drawings, and more particularly first to Figures 1 - 9, there is illustrated a method of creating a relief structure on the surface of an amorphous solid fused silica, $SiO_2$, substrate and thereafter producing thereon an epitaxial or preferred orientation layer of silicon. The fused silica, $SiO_2$, substrate 1 is first covered with a thin film of evaporated or sputtered chromium 2 about 20 nm (200 Å) thick. This is then covered with about 5000 Å of photoresist 3 such as AZ 1350B (a product of the Shipley Company, Newton, Mass.) and exposed in a pattern by passing ultraviolet radiation 4 through a photomask 5 having a grating pattern 6. Alternatively, holographic lithography could be used to expose a grating in the photoresist, and, in place of AZ 1350B, another radiation sensitive polymer film could be substituted and the exposure of a pattern could be done by means of X-ray lithography (as described in our copending patent application Reference GJE 5180/066) electron beam lithography, ion beam lithography or other means. Although the mask 5 in FIG. 2 is shown out of contact with the resist film 3, in practice intimate contact is preferred in order to ensure a faithful replication of the mask pattern. In one series of experiments reported in the article by M. W. Geis, D. C. Flanders and H. I. Smith cited above, the spatial period of the grating pattern 6 was 3.8 μm.

After exposure of the resist 3, a development step removed the exposed regions, leaving a grating relief structure in resist 3 on top of the chromium 2, as illustrated in FIG. 3. The chromium was then etched in an aqueous chemical etchant (a mixture of 164.5 grams of Ceric ammonium nitrate, 43 milliliters of concentrated perchloric acid (70%) with water added to make 1 liter/ and the resist dissolved in a solvent or removed in an oxygen plasma or ozone. The $SiO_2$ substrate, masked by the chromium grating, 2 in FIG. 4, was then etched to a depth of about 1000 Å using a reactive ion etching process (see article by D. C. Flanders and H. I. Smith, "Surface

Relief Structures With Linewidths Below 2000 Å", Applied Physics Letters, Vol. 32, pp. 112-114, 15 January 1978), thereby yielding a relief grating, 7, in the $SiO_2$ as shown in FIG. 5. Following this, the chromium was removed using the same chemical etchant formulation cited above.

Next, a thin film of silicon, 8 in FIG. 6, about 5000 Å thick, was deposited over the relief structure 7 in the $SiO_2$ by a chemical vapor deposition process in a commercial system designed for such silicon deposition. The temperature of deposition was 610°C so as to yield an amorphous film of silicon. Following this, as illustrated in FIG. 7, an argon laser beam, 9, was focused onto the silicon film, using lens 10, and the substrate was scanned, in a raster fashion, past the beam, using a simple mechanical scanning platform, 11. This process has been called "laser annealing" or "Laser crystallization" and is well-known in the modern art (see, for example, U. S. Patent No. 4,059,461 by J. C. C. Fan and Herbert J. Zeiger, "Method for Improving the Crystallinity of Semiconductor Films by Laser Beam Scanning and the Products Thereof"). At an appropriate power density, which appears to be around the region of melting, the amorphous silicon converts, upon cooling, to a polycrystalline form. On smooth amorphous fused silica substrates, this polycrystalline silicon was found to have a substantially (100) texture (that is, (100) planes of the individual crystallites tend to be parallel to the fused silica substrate) if the laser crystallization was done in air. When the laser crystallization was done in air over that region of the substrate containing a grating relief structure, 7, the silicon became oriented by the relief structure. The degree of completeness of the orientation was increased with additional raster scans of the substrate under the laser beam. The <100> crystallographic directions of this silicon (that had been laser crystallized inside the grating area) were substantially parallel and perpendicular to the grating and perpendicular to the plane of the $SiO_2$ surface. In areas outside the grating, many discrete silicon crystallites were observed. These tended to have one of their three <100> directions perpendicular to the $SiO_2$ surface and the other two randomly directed in the plane of the surface. Thus, a substantially epitaxial film was obtained only over the surface relief structure, indicating that crystallographic orientation was determined, controlled or influenced by the artificial defects, and that the energy input from the laser induced or enhanced the orienting influence. The above results demonstrate the principle of the invention.

Under certain circumstances, the orienting influence of artificial defects may not depend on the adjacency of other defects. Instead, the geometric arrangement (that is, the position, orientation and geometric form) of a single defect can be sufficient to induce crystallographic orientation. For example, consider the situation depicted in FIG. 8. A substrate 12, has a relief step 13 etched into its surface. The substrate is covered with an amorphous or polycrystalline film 14, and an incident beam 15 of electrons, ions, electromagnetic radiation or other form of energy input is scanned over the film, past the relief step, 13. As a result of energy input from the beam 15, crystallization is nucleated at the relief step 13, and the crystal or crystals thus formed are oriented in accordance with the geometric form of the relief step. These crystals can then act as seeds from which further oriented crystal growth can be extended over large distances. Such extension of the crystal growth can be induced, for example, by additional scanning of the beam 15, by scanning with other beams, or by annealing at elevated temperature.

As a specific example, consider the case of a smooth amorphous substrate, such as thermally grown $SiO_2$, over a silicon wafer on top of which a 0.5 μm thick film

- 8 -

of amorphous silicon has been deposited by a CVD process. We have observed that when such a film is heated to a suitable high temperature by scanning it under an argon ion laser beam (using an apparatus such as shown in Figure 7), the amorphous silicon crystallizes with a (111) texture (that is, a multiplicity of crystals form which have (111) planes parallel to the substrate surface, but random orientation in the plane of the substrate). If instead of a smooth surface, a relief step is etched into the surface, such as depicted as 13 in Figure 8, and further if the angle of intersection of the facets of the relief step is 70.5$^{\circ}$ (corresponding to the angle of intersection of (111) planes in a cubic crystal—silicon being a cubic crystal), then the crystal nucleation that takes place at the relief step, when the substrate is passed under the laser beam, will have one of its (111) directions oriented predominantly perpendicular to the plane of the inclined facet in Figure 8. The crystal or crystals, oriented by the single relief step, can then serve as the starting point for more extensive crystallization, which would have orientation determined by the orientation of the crystal or crystals formed initially at the relief step 13.

Another specific improvement on our basic invention is depicted in Figure 9. The relief structure includes facets which intersect at 70.5$^{\circ}$ and 109.5$^{\circ}$, corresponding to the intersection angles of the (111) planes in cubic crystals. Such a relief structure would be preferred for obtaining epitaxial or preferred orientation films having (111) planes parallel to the substrate surface plane.

# 0020134

- 9 -
CLAIMS GJE 5180/064

1. A method of enhancing epitaxy and preferred orientation in films on solid substrates, which method includes the steps of intentionally forming at predetermined locations, a plurality of artificial defects (7) at the surface of a solid substrate (1) and thereafter depositing a film (8) on the surface to form a substantially epitaxial or preferred orientattion layer in the film having crystalographic orientattion influenced by the geometry of an artificial defect, characterized in that the orienting influence of the artificial defects is enhanced by applying an incident beam of energy (9) to the film (8).

2. A method according to claim 1, wherein the beam (9) is an electron beam.

3. A method according to claim 1, wherein the beam (9) is an ion beam.

4. A method according to claim 1, wherein the beam is a beam of electromagnetic energy.

5. A method of enhancing epitaxy and preferred orientation in films on solid substrates, the method including the step of intentionally forming, at a predetermined location, an artificial defect at the surface of a solid substrate, the artificial defect comprising an artificial point defect or an artificial step, and thereafter depositing a film on the surface to form a substantially epitaxial or preferred orientation layer in the film having crystallographic orientation controlled by the geometry of the articial defect.

6.      A method according to claim 5, further including the step of forming the artificial defect with its dimension in a direction perpendicular to the substrate surface within the range of one atom to 1/2 micron.

7.      A method according to claim 5 or claim 6, wherein the substrate comprises an amorphous solid substrate.

8.      A method according to any of claims 5 to 7, wherein at predetermined locations, a further artificial defect is formed at the surface of the solid substrate, the further artificial defect comprising an artificial point defect or an artificial step, the crystallographic orientation of the film subsequently deposited being influenced by the geometry of the further artificial defect.

9.      A substrate having an epitaxial or preferred orientation layer on its surface, formed by a method according to any of claims 5 to 8.

10.      A method of enhancing epitaxy and preferred orientation in films on solid substrates which method includes the steps of intentionally forming at predetermined locations a plurality of artificial defects at the surface of a solid substrate, the artificial defects comprising artificial point defects or artificial surface relief structure, and thereafter depositing a film on the surface to form a substantially epitaxial or preferred orientation layer in the film having crystallographic orientation controlled by the geometric arrangement of adjacent artificial defects characterized in that artificial steps having sloping walls are formed among the artificial defects, the sloping walls being parallel to one another and inclined at an angle of substantially $70.5^{\circ}$ or $109.5^{\circ}$ to the substrate surface.

FIG. 1

FIG. 2

FIG. 3

FIG. 4

FIG. 5

FIG. 6

FIG. 8

FIG. 9

70.5°   109.5°

*FIG. 7*

**European Patent Office**

**EUROPEAN SEARCH REPORT**

0020134

Application number

EP 80 30 1761

| Category | Citation of document with indication, where appropriate, of relevant passages | Relevant to claim |
|---|---|---|
| A | APPLIED PHYSICS LETTERS, vol. 32, no. 6, 15th March 1978, pages 349-350 H.I. SMITH et al.: "Oriented crystal growth on amorphous substrates using artificial surface-relief gratings" <br> * Page 350, column 1, paragraph 2 * | 1 |
| A | DE - A - 2 454 183 (FRAUNHOFER) <br> * Claims 1,2 * | 1,10 |
| P,A | FR - A - 2 426 496 (MASSACHUSETTS INSTITUTE OF TECHNOLOGY) | |
| A | US - A - 4 059 461 (J.C.C. FAN) | |

**CLASSIFICATION OF THE APPLICATION (Int. Cl. 3)**

C 30 B   1/08
C 30 B 25/18
C 23 C 13/04

**TECHNICAL FIELDS SEARCHED (Int.Cl. 3)**

C 30 B   1/08
        25/18
C 23 C 13/04
C 30 B   1/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 21-08-1980 | BRACKE |

EPO Form 1503.1   06.78